# EUROPÄISCHE PATENTSCHRIFT

(11) **EP 2 400 562 B1**
(45) Veröffentlichungstag und Bekanntmachung des Hinweises auf die Patenterteilung: **21.11.2018**
(21) Anmeldenummer: 11166658.2
(22) Anmeldetag: 19.05.2011
(51) Int. Cl.: H02S 40/34, H02S 40/36, H01L 31/05

(54) **Verbindungseinrichtung anordenbar zu einem Photovoltaikmodul**
Connection device which can be fixed to a photovoltaic module
Dispositif de liaison pouvant être agencé sur un module photovoltaïque

(30) Priorität: 24.06.2010 DE 102010030478
(43) Veröffentlichungstag der Anmeldung: 28.12.2011
(73) Patentinhaber: SEMIKRON Elektronik GmbH & Co. KG, 90431 Nürnberg (DE)
(72) Erfinder: Halaj, Jan, 921 01 Piestany (SK); Göbl, Christian, 90441 Nürnberg (DE); Kavicky, Pavel, 921 01 Piestany (SK); Mateicka, Marian, 956 07 Behynce (SK); Starovecky, Stefan, 921 01 Piestany (SK)

(56) Entgegenhaltungen:
- WO-A1-2008/000101
- WO-A2-2009/129405
- DE-A1-102008 022 056

## Beschreibung

Die Erfindung beschreibt eine Verbindungseinrichtung, auch bekannt als Junction Box, Derartige Verbindungseinrichtungen sind üblicherweise direkt an einem Photovoltaikmodul angeordnet und dienen der elektrischen Verbindung zu weiteren Photovoltaikmodulen und auch der elektrischen Verbindung zu einer Wechselrichtereinrichtung. Üblicherweise sind in einer Photovoltaikanlage die einzelnen Photovoltaikmodule in Reihe und mit der Wechselrichtereinrichtung verbunden, wofür die Verbindungseinrichtung noch eine, meist als Bypass-Dioden ausgestaltet, Halbleiterschaltungsanordnung aufweist. Diese Halbleitereinrichtung kann auch abhängig von der internen Verschaltung des Photovoltaikmoduls eine Mehrzahl von in Reihe geschalteten Bypass-Dioden aufweisen.

Diese Halbleitereinrichtung hat somit meist die Aufgabe im Fehlerfall des zugeordneten Photovoltaikmoduls dieses zu überbrücken und den Stromfluss in der gesamten Photovoltaikanlage zu gewährleisten.

Aus der DE 10 2006 027 104 B3 ist beispielhaft eine Verbindungseinrichtung bekannt, die gegenüber anderen beispielhaft offenbart in der DE 10 2007 020 846 A1 oder der DE 10 2008 022 056 A1, über ein Metallgehäuse verfügt. Diese Metallgehäuse verbessert die Kühlung der Halbleiterbauelemente im Inneren der Verbindungseinrichtung, indem diese randnah an den Seitenrändern angeordnet sind. Aus beiden Ausführungsformen von gattungsgemäßen Verbindungseinrichtungen sind erst Anschlusseinrichtungen zur Verbindung mit dem Photovoltaikmodul sowie zweite Anschlusseinrichtungen zur Verbindung innerhalb der Photovoltaikanlage bekannt. Ebenso bekannt sind hieraus Halbleiterbauelemente vornehmlich in der Funktion von Bypass-Dioden, die schaltungsgerecht mit den Anschlusseinrichtungen verbunden sind.

Der Erfindung liegt die Aufgabe zugrunde eine Verbindungseinrichtung zur Anordnung zu einem Photovoltaikmodul vorzustellen, wobei die Gesamtheit der Halbleiterbauelemente einem Funktionstest einfach, ohne Photovoltaikmodul, zugänglich ist, gleichzeitig im Betriebe einer effizienten Kühlung zugänglich ist und zudem im Fehlerfall mit wenig Aufwand ersetzbar ist.

Die Aufgabe wird erfindungsgemäß gelöst, durch eine Verbindungseinrichtung mit den Merkmalen des Anspruchs 1. Bevorzugte Ausführungsformen sind in den jeweiligen abhängigen Ansprüchen beschrieben.

Ausgangspunkt der Erfindung ist eine Verbindungseinrichtung anordenbar zu einem Photovoltaikmodul zur elektrischen Verbindung einer Mehrzahl von Photovoltaikmodulen miteinander und / oder mit einer Wechselrichtereinrichtung, wie sie in einer Reihenschaltung der Photovoltaikmodule üblich sind.

Die erfindungsgemäße Verbindungseinrichtung weist ein Gehäuse auf, das aus mindestens, vorzugsweise genau zwei Teilgehäusen besteht und erste und zweite Anschlusseinrichtungen aufweist. Hierbei ist es bevorzugt, wenn der erste Gehäuseteil direkt auf dem Photovoltaikmodul, typischerweise auf dessen Rückseite, angeordnet und stoffschlüssig verbunden ist. Von dem Photovoltaikmodul gehen mindestens zwei, häufig mehr, Gleichstromverbindungskabel oder -verbindungsflachleiter aus, die mit ersten Anschlusseinrichtungen der Verbindungseinrichtung elektrisch leitend verbindbar sind. Die Durchführung dieser Kabel oder Flachleiter erfolgt gemäß dem Stand der Technik nach notwendigem Schutz vor Feuchtigkeit und mit notwendiger elektrischer Isolation. Grundsätzlich stehen als Materialien Kunststoff, wie auch Metall oder Mischformen, beispielhaft mit einem ersten Teilkörper aus Kunststoff und einem zweiten Teilkörper aus Metall, als Ausgestaltungen des Gehäuses zur Verfügung.

Die ersten Anschlusseinrichtungen sind hierbei in dem ersten Teilgehäuse angeordnet. Es sind auch die zweiten Anschlusseinrichtungen zur seriellen Verbindung des Photovoltaikmoduls über die Verbindungseinrichtung innerhalb der Photovoltaikanlage in dem ersten Teilgehäuse angeordnet. Somit entsteht eine Verbindungseinheit zur vollständigen externen elektrischen Verbindung der Verbindungseinrichtung.

In dem zweiten Teilgehäuse ist eine Halbleiterschaltungsanordnung als eine funktionale Einheit angeordnet, die alle Halbleiterbauelement, wie auch deren vollständige Verschaltungseinrichtung umfasst. Somit ergibt sich eine Halbleitereinheit aus dem zweiten Gehäuseteil und der Halbleiterschaltungsanordnung die als solche einem vollständigen elektrischen Test zugänglich ist.

Diese Halbleiterschaltungsanordnung ist ausgestaltet mit bevorzugt nur einem elektrisch isolierenden Substrat und hierauf ausgebildeten Leiterbahnen. Auf diesen Leiterbahnen sind die Halbleiterbauelemente der Halbleiterschaltungsanordnung als ungehauste Bauelement angeordnet und schaltungsgerecht verbunden. Zur elektrischen Isolation wie auch zur Wärmespreizung der entstehenden Verlustwärme ist die Halbleiterschaltungsanordnung mit einer Vergussmasse bedeckt.

Alternativ kann es vorteilhaft sein die Halbleiterbauelement als gehauste Bauelemente auszubilden und kraftschlüssig in jeweiligen schaltungsgerecht verbundenen Druckkontakteinrichtungen anzuordnen.

Grundsätzlich können auch weitere Ausgestaltungen bevorzugt sein, besonders auch geeignete Mischformen der beiden explizit genannten. All diesen Ausgestaltungen ist die elektrische Testbarkeit auch ohne angeordneten ersten Teilkörper bzw. ohne zugeordnetes Photovoltaikmodul gemeinsam.

Erfindungsgemäß ist eine Ausnehmung in dem ersten Teilkörper vorgesehen, die durch die eine Kühleinrichtung aus dem Inneren des Gehäuses hindurchreicht und wobei hierbei diese Ausnehmung selbstverständlich ausreichend gegen Umwelteinflüsse abgedichtet ist.

Erfindungsgemäß weist der zweite Teilkörper noch zweite Kontakteinrichtungen auf, die die Schaltungsanordnung mit den Anschlusseinrichtungen des ersten Teilkörpers, die hierzu erste Kontakteinrichtungen aufweisen, elektrisch leitend zu verbinden. Diese Kontakteinrichtungen sind vorteilhafterweise als Steck- oder Federkontakte ausgebildet. Durch diese reversible elektrische und eine geeignete mechanische Verbindung wird eine Verbindungseinrichtung geschaffen, bei der die Halbleiterbauelemente bei einem Defekt auch im Betrieb in einer Photovoltaikanlage ersetzt werden kann.

Die erfinderische Lösung wird an Hand der Ausführungsbeispiele gemäß den Fig. 1 bis 5 weiter erläutert.
Fig. 1 zeigt schematisch eine Photovoltaikanlage mit erfindungsgemäßen Verbindungseinrichtungen.
Fig. 2 zeigt eine Prinzipskizze einer erfindungsgemäßen Verbindungseinrichtung.
Fig. 3 zeigt eine Verbindungseinrichtung zur weiteren Erläuterung der Erfindung.
Fig. 4 zeigt eine Ausgestaltung einer erfindungsgemäßen Verbindungseinrichtung.
Fig. 5 zeigt eine Halbleiterschaltungsanordnung einer erfindungsgemäßen Verbindungseinrichtung.

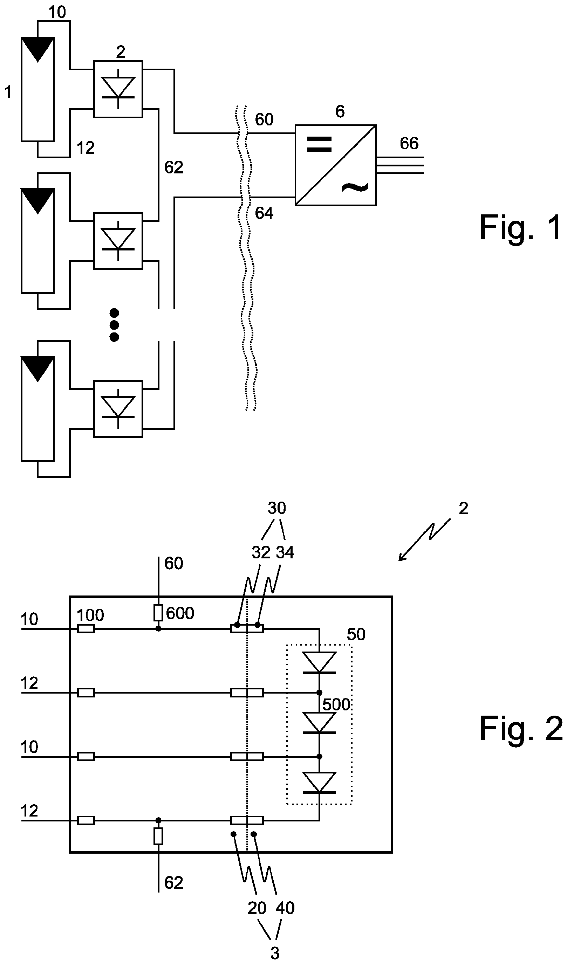

Fig. 1 zeigt schematisch eine Photovoltaikanlage mit einer Mehrzahl von Photovoltaikmodulen (1) mit jeweils diesen Photovoltaikmodulen (1) zugeordneter erfindungsgemäßer Verbindungseinrichtung (2). Es ist bevorzugt diese jeweilige Verbindungseinrichtung (2) unmittelbar auf der Rückseite des Photovoltaikmoduls (1) anzuordnen und mit dessen Gleichstromverbindungskabel oder -flachleiter (10, 12) elektrisch leitend zu verbinden.

Die Photovoltaikmodule (1) sind mittels der zugeordneten Verbindungseinrichtungen (2) seriell miteinander und mit einer Wechselrichtereinrichtung (6) über jeweilige Verbindungskabel (60, 62, 64) verbunden. Mittels dieser Wechselrichtereinrichtung (6) wird der in den Photovoltaikmodulen (1) erzeugte Gleichstrom in Wechselstrom gewandelt und in ein Stromnetz (66) eingespeist wird. Die Verbindungseinrichtung (2) dient nicht hierbei nicht nur der genannten elektrischen Verbindung sondern auch der Überbrückung einzelner Photovoltaikmodule (1) im Fehlerfall. In diesem Fehlerfall liefert das Photovoltaikmodul (1) keinen Strom und weist auch keine Leitfähigkeit auf. Für diesen Fehlerfall weisen die Verbindungseinrichtungen (2) eine Halbleiterschaltungsanordnung (vgl. Fig. 2, 50) auf, die zumindest als Bypass fungieren kann.

Fig. 2 zeigt eine Prinzipskizze einer erfindungsgemäßen Verbindungseinrichtung (2) mit einem aus zwei Teilgehäusen (20, 40) bestehenden Gehäuses (3). Durch die interne Verschaltung eines jeweiligen Photovoltaikmoduls (1) weist dieses häufig mehr als die zwei notwendigen Gleichstromverbindungskabel oder -flachleiter (10, 12) auf.

Diese, bei der dargestellten Ausgestaltung, vier Gleichstromverbindungskabel oder -flachleiter (10, 12) sind in der Verbindungseinrichtung (2) mit ersten Anschlusseinrichtungen (100) verbunden. Diese ersten, im ersten Teilgehäuse angeordneten, Anschlusseinrichtungen (100) sind weiterhin mit ersten Kontakteinrichtungen (32) ebenfalls angeordnet im ersten Teilgehäuse (20) verbunden, die jeweils mit zugeordneten zweiten Kontakteinrichtungen (34) des zweiten Teilgehäuses (40) kontaktierbar ausgebildet sind.

In diesem zweiten Teilgehäuse (40) ist die Halbleiterschaltungsanordnung (50) vorgesehen und besteht hier aus drei Dioden (500), die eine Bypassfunktion für das Photovoltaikmodul (vgl. Fig. 1, 1) ausbilden. Die zweiten Anschlusseinrichtungen (600) zur Verbindung mit weiteren Verbindungseinrichtungen (2) bzw. der Wechselrichtereinrichtung (6) sind hier ebenfalls in bevorzugter Weise in dem ersten Teilgehäuse (20) angeordnet. Grundsätzlich ist allerdings auch eine Anordnung im zweiten Teilgehäuse (40) möglich, wenn auch nicht bevorzugt.

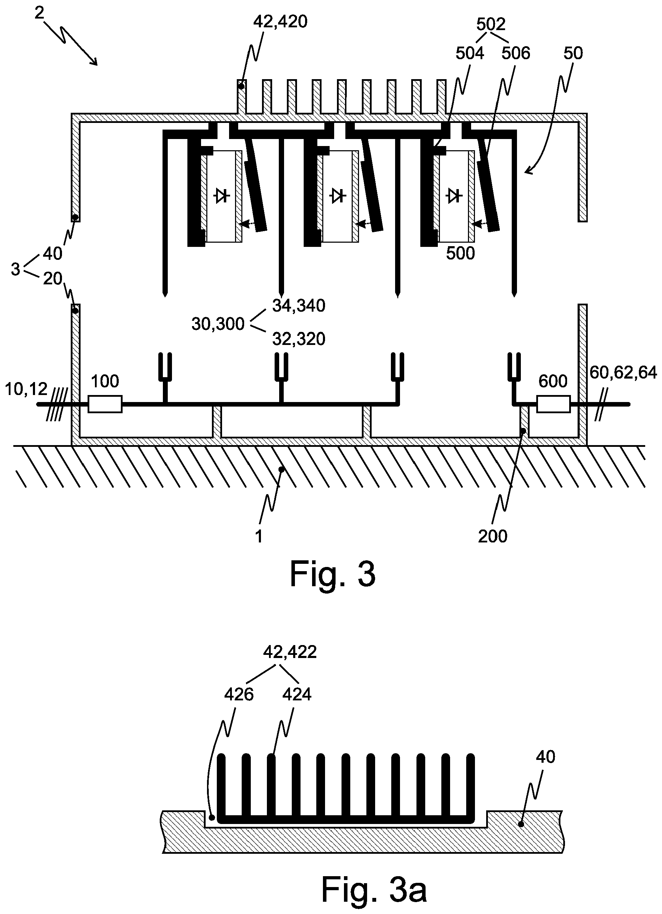

Fig. 3 zeigt als Prinzipskizze eine Verbindungseinrichtung (2) direkt angeordnet auf der Rückseite eines Photovoltaikmoduls (1). Von diesem Photovoltaikmodul (1) führen Gleichstromverbindungskabel (10, 12) in die Verbindungseinrichtung (2), wobei hierbei selbstverständlich ein notwendiger Schutz des Inneren der Verbindungseinrichtung gegen Umwelteinflüsse vorgesehen ist. Diese Gleichstromverbindungskabel sind mit ersten Anschlusseinrichtungen (100) verbunden. Ebenso dargestellt sind zweite Anschlusseinrichtungen (600), wie auch die damit verbundenen Kabel (60, 62, 64) der seriellen Verbindung innerhalb der Photovoltaikanlage. Diese ersten und zweiten Anschlusseinrichtungen (100, 600) sind jeweils in dem ersten Teilkörper (20) des Gehäuses (3) der Verbindungseinrichtung (2) angeordnet und bilden somit deren Verbindungseinheit aus.

In dem zweiten Teilkörper (40) des Gehäuses (3) der Verbindungseinrichtung (2) ist die Halbleiterschaltungsanordnung (50) angeordnet, wodurch die Halbleitereinheit ausgebildet wird. Die Halbleiterschaltungsanordnung (50) besteht hierbei aus einer Mehrzahl von Druckkontakteinrichtungen (502), die direkt, ggf. elektrisch isoliert mit dem zweiten Teilgehäuse (40) verbunden sind. In diesen Druckkontakteinrichtungen (502) sind gehauste Halbleiterbauelemente (500), vorzugsweise Leistungsdioden, angeordnet und kraftschlüssig verbunden. Beispielhaft weisen die Druckkontakteinrichtungen (502) hierzu jeweils eine Aufnahme (504) und ein Druckelement (506) mit einem federnden Abschnitt auf.

Vorteilhafterweise ist das zweite Teilgehäuse (40) aus einem isolierenden, thermisch ausreichend leitfähigem Kunststoff ausgebildet und weist an seiner der Halbleiterschaltungsanordnung (50) oder Teilen hiervon zugeordneten, unmittelbar benachbarten, Außenseite eine Mehrzahl von Kühlmitteln (420) auf. Diese sind in der einfachsten Ausgestaltung einstückig aus dem zweiten Teilkörper (40) selbst ausgebildet. Es kann bei höherer thermischer Belastung das zweite Teilgehäuse (40) aus einem metallischen Werkstoff auszubilden. Alternativ hierzu kann es auch bevorzugt sein die Außenwand eines Kunststoffgehäuses in dem bezeichneten Bereich dünner auszugestalten (426) und außen einen metallischen Kühlkörper (424) vorzusehen, wie in Fig. 3a dargestellt.

Zur elektrischen Verbindung der Halbleiterschaltungsanordnung (50) des zweiten Teilkörpers (40) mit den ersten und zweiten Anschlusseinrichtungen (100, 600) des ersten Teilkörpers (20) sind erste (32) und zugeordnete zweite Kontakteinrichtungen (34) vorgesehen. Die jeweils erste Kontakteinrichtung (32) ist hierbei im ersten Teilkörper (20) angeordnet, während die jeweils zugeordneten zweiten Kontakteinrichtungen (34) im zweiten Teilkörper (40) angeordnet sind. Diese jeweiligen Kontakteinrichtungen (32, 34) sind bei dieser Ausgestaltung der Verbindungseinrichtung als Steckverbinder (320, 340) ausgebildet und schießen den jeweiligen Kontakt zwischen der ersten (32) und zugeordneten zweiten Kontakteinrichtung (34) bei der Anordnung des ersten (20) zum zweiten Teilkörper (40).

Somit kann der erste Teilkörper (20) mit seinen Anschlusseinrichtungen (100, 600) auf der Rückseite des Photovoltaikmoduls (1) angeordnet und die gesamte Photovoltaikanlage vollständig elektrisch verbunden werden, ohne dass bereits die Halbleiterschaltungsanordnung (50) selbst vorhanden sein muss. Dies bedeutet ebenso, dass die Halbleiterschaltungsanordnung (50), als Teil der Halbleitereinheit, unabhängig von der Verbindungseinheit elektrischen Tests unterzogen werden kann. Ebenso bedeutet dies, dass die Halbleitereinheit einfach, ohne die Verbindungen (60, 62, 64) der Photovoltaikanlage auch nur teilweise demontieren zu müssen im Fehlerfall ersetzt werden kann.

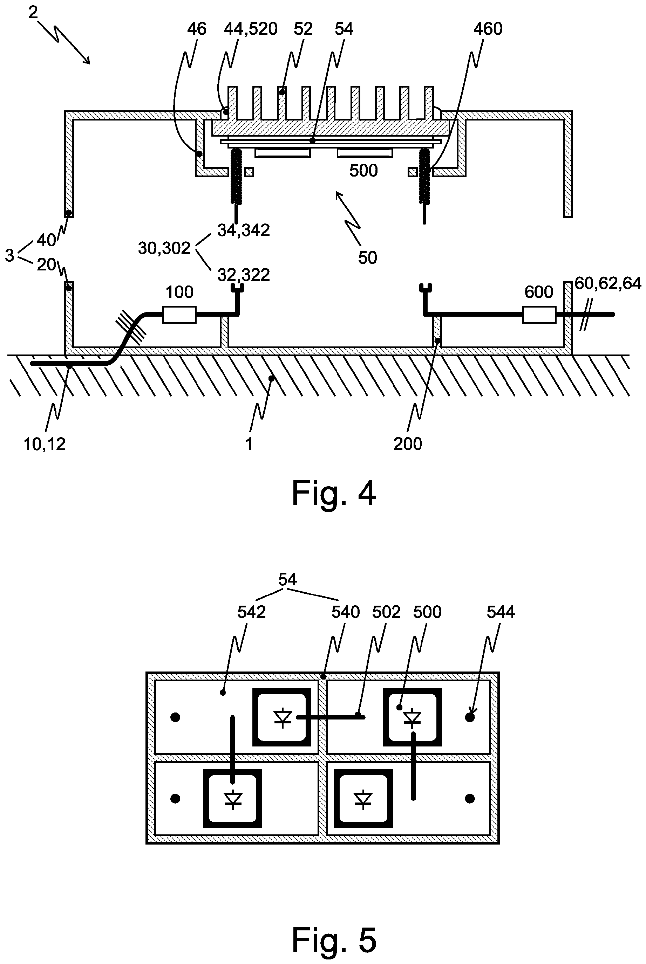

Fig. 4 zeigt als Prinzipskizze eine Ausgestaltung einer erfindungsgemäßen Verbindungseinrichtung (2). Der erste Teilkörper (20) des Gehäuses (3) unterscheidet sich hierbei von demjenigen gemäß Fig. 3 dadurch, dass hier Gleichstromflachleiter (10, 12) als Teil des Photovoltaikmoduls (1) vorgesehen sind und diese auf der dem Photovoltaikmodul (1) zugewandten Seite der Verbindungseinrichtung (2) in diese hinein führen. Selbstverständlich ist hierbei ebenfalls ein notwendig Schutz gegen Umwelteinflüsse vorgesehen.

Weiterhin sind als zweite Kontakteinrichtungen (34), verbindbar mit ersten Kontakteinrichtungen (32), hierbei Aufnahmen (322) vorgesehen, die einen sicheren Kontakt zu einer Kontaktfeder (342) als zweiter Kontakteinrichtung gewährleisten.

Wesentlich unterscheiden sich das zweite Teilgehäuse (40) des Gehäuses (3) und auch die dort vorgesehene Halbleiterschaltungsanordnung (50) dieser Ausgestaltung von derjenigen gemäß Fig. 3. Das zweite Teilgehäuse (40) weist hier eine Öffnung (44) auf, die vorgesehen ist um hierin eine Kühleinrichtung (52) in Form eines der Halbleiterschaltungsanordnung (50) zugeordneten Kühlkörpers anzuordnen und mittels einer Dichteinrichtung (520) gegen Umwelteinflüsse abzudichten. Es ist hier bevorzugt und auf Grund der thermischen Belastung meist ausreichend, wenn die Kühleinrichtung (52) eine passive Kühleinrichtung in Form eines Aluminiumkühlkörpers ist. Für besondere Anwendungen kann allerdings auch eine aktive Kühleinrichtung, beispielhaft ausgestattet mit einem zusätzlichen Ventilator bevorzugt sein.

Auf diesem Kühlkörper (52) dem Inneren des Gehäuses (3) zugewandt ist die Halbleiterschaltungsanordnung (50) vorgesehen. Diese besteht aus einem gegen den Kühlkörper (52) elektrisch isolierten aber thermisch sehr gut leitfähigen Substrat (54). Besonders vorteilhaft sind hierfür sog. DCB- (direct copper bonded) Substrate, geeignet sind allerdings auch je nach Anforderung an die thermische Leitfähigkeit IMS- Substrate oder einfache Leiterplatten.

Das Substrat (54) weist grundsätzlich eine Mehrzahl von Leiterbahnen (542) mit bevorzugt ungehausten Halbleiterbauelementen (500) auf, die schaltungsgerecht miteinander, beispielhaft mittels Drahtbondverbindungen oder mittels einer flexiblen Leiterstruktur schaltungsgerecht verbunden sind. Bei Verwendung ungehauster Halbleiterbauelemente (500) ist es weiterhin besonders bevorzugt diese mit einer nicht dargestellten Isolierstoffmasse, wie beispielhaft Silikonkautschuk zu bedecken

Als zweite Kontakteinrichtungen (34) sind in dieser Ausgestaltung Kontaktfedern (342) vorgesehen, die vorzugsweise mittels Halteeinrichtungen (46, 460), die ein- oder mehrstückig mit dem zweiten Teilgehäuse (40) ausgebildet sind in diesem gehaltert sind.

Bei Anordnung des ersten (20) zum zweiten Teilgehäuse (40) werden die Kontaktfeder (342) mit Druck beaufschlagt und bilden mit den ersten Kontaktelementen (32), den Aufnahmen (322) im ersten Teilgehäuse (20) eine sicher aber auch vollständig reversible elektrische Verbindung aus. Selbstverständlich sind im ersten Teilgehäuse (20) notwendige Widerlager (200) zur Erzeugung eines Gegendrucks für diese Federkontaktierung (302) vorgesehen.

Grundsätzlich ist es ebenso möglich erste und zweite Kontakteinrichtungen (32, 34) funktional zu tauschen, also als erste Kontakteinrichtung eine Kontaktfeder und als zweite Kontakteinrichtung eine zugeordnet Aufnahme vorzusehen.

Ebenso ist kann es vorteilhaft sein Merkmale der Ausgestaltung einer der beiden Verbindungseinrichtung durch Merkmal der jeweils anderen zu ersetzen oder zu kombinieren. Dies bezieht sich insbesondere auf die Ausgestaltung der Kühleinrichtung wie auch auf die Ausgestaltung der ersten und zweiten Kontakteinrichtungen.

Fig. 5 zeigt eine Halbleiterschaltungsanordnung (50) einer erfindungsgemäßen Verbindungseinrichtung (3). Dargestellt ist ein Substrat (54) mit einem Isolierstoffgrundkörper (540) und hierauf angeordneten Leiterbahnen (542), wobei auf jeder Leiterbahn stoffschlüssig ein Halbleiterbauelement (500), hier eine Leistungsdiode und eine Kontaktfläche (544) für die Kontaktfeder (vgl. Fig. 4, 342) angeordnet sind. Weiterhin schematisch ist die schaltungsgerechte Verbindung (502) der Leistungsdioden (500) dargestellt, die hier auf sehr einfach weise beispielhaft mittels eines Folienverbunds aus einer Isolierstofffolie und einer Metallfolie, die hierbei in sich strukturiert ist, ausgebildet werden kann. Ebenso kann diese schaltungsgerechter Verbindung mittels Bonddrähten erfolgen.

## Patentansprüche

1. Verbindungseinrichtung (2) anordenbar zu einem Photovoltaikmodul (1) zur elektrischen Verbindung einer Mehrzahl von Photovoltaikmodulen (1) miteinander und / oder mit einer Wechselrichtereinrichtung (6) mindestens aufweisend ein Gehäuse (3) mit mindestens einem ersten, direkt auf dem Photovoltaikmodul (1) anordenbarem, Teilgehäuse (20) und einem zweiten Teilgehäuse (40),
erste Anschlusseinrichtungen (100) zur elektrischen Verbindung mit dem Photovoltaikmodul (1) angeordnet in dem ersten Teilgehäuse (20),
zweite Anschlusseinrichtungen (600) zur elektrischen Verbindung mit einer weiteren Verbindungseinrichtung (2) oder der Wechselrichtereinrichtung (6) angeordnet im ersten Teilgehäuse (20)
einer Halbleiterschaltungsanordnung (50) mit mindestens einem Halbleiterbauelement (500) angeordnet in dem zweiten Teilgehäuse (40) und erste (32), dem ersten Teilgehäuse (20) zugeordnete, und zweite (34), dem zweiten Teilgehäuse (40) zugeordnete, Kontakteinrichtungen (30) wodurch die Halbleiterschaltungsanordnung (50) mit den ersten Anschlusseinrichtungen (100) elektrisch verbindbar ist, wobei
die Halbleiterschaltungsanordnung (50) als eine funktionale Einheit mindestens ein elektrisch isolierendes Substrat (54) aufweist mit hierauf angeordneten Leiterbahnen (542) und mit diesen stoffschlüssig verbundene Halbleiterbauelemente (500) aufweist und wobei
eine Kühleinrichtung (52) in thermischem Kontakt mit dem Substrat der Halbleiterschaltungsanordnung (50) vorgesehen ist und in einer Aussparung (44) des zweiten Teilgehäuses (40) angeordnet ist.

2. Verbindungseinrichtung nach Anspruch 1, wobei
mittels der zweiten Anschlusseinrichtungen (600) im ersten Teilgehäuse (40) die Halbleiterschaltungsanordnung (50) mit den zweiten Anschlusseinrichtungen (600) elektrisch verbindbar ist.

3. Verbindungseinrichtung nach Anspruch 1, wobei
die Halbleiterschaltungsanordnung (50) eine Mehrzahl von Druckkontakteinrichtungen (502) mit jeweils einem gehausten Halbleiterbauelement (500) zu dessen kraftschlüssiger Kontaktierung aufweist.

4. Verbindungseinrichtung nach Anspruch 1, wobei
die ersten und zweiten Kontakteinrichtungen (30) die Halbleiterschaltungsanordnung (50) schaltungsgerecht mit den zweiten Anschlusseinrichtungen (600) verbinden.

5. Verbindungseinrichtung nach Anspruch 1 oder 3, wobei ersten und zweiten Kontakteinrichtungen (30) als Steckkontakteinrichtung (300) ausgebildet sind.

6. Verbindungseinrichtung nach Anspruch 1 oder 3, wobei ersten und zweiten Kontakteinrichtungen (30) als Federkontakteinrichtung (302) ausgebildet sind, die bei Anordnung des ersten (20) zum zweiten Teilgehäuse (40) mit Druck beaufschlagt sind.

## Claims

1. Connecting device (2) which can be arranged relative to a photovoltaic module (1) for the purpose of electrically connecting a plurality of photovoltaic modules (1) to one another and/or to an inverter device (6) having at least a housing (3) having at least a first housing element (20), which can be arranged directly on the photovoltaic module (1), and a second housing element (40),
first connection devices (100) for electrical connection to the photovoltaic module (1) arranged in the first housing element (20),
second connection devices (600) for electrical connection to a further connecting device (2) or to the inverter device (6) arranged in the first housing element (20) of a semiconductor circuit arrangement (50) having at least one semiconductor component (500) arranged in the second housing element (40), and
first (32) contact devices (30), which are associated with the first housing element (20), and second (34) contact devices (30), which are associated with the second housing element (40), as a result of which the semiconductor circuit arrangement (50) can be electrically connected to the first connection devices (100), wherein the semiconductor circuit arrangement (50) as a functional unit has at least one electrically insulating substrate (54) with interconnects (542) arranged thereon and with semiconductor components (500) materially connected thereto, and wherein a cooling device (52) is provided in thermal contact with the substrate of the semiconductor circuit arrangement (50) and is arranged in a cutout (44) in the second housing element (40).

2. Connecting device according to Claim 1, wherein the semiconductor circuit arrangement (50) can be electrically connected to the second connection devices (600) in the first housing element (40) by means of the second connection devices (600).

3. Connecting device according to Claim 1, wherein the semiconductor circuit arrangement (50) has a plurality of push contact devices (502) having a respective packaged semiconductor component (500) for making force-fit contact therewith.

4. Connecting device according to Claim 1, wherein the first and second contact devices (30) connect the semiconductor circuit arrangement (50) to the second connection devices (600) in accordance with the circuitry.

5. Connecting device according to Claim 1 or 3,
wherein
the first and second contact devices (30) are in the form of a plug contact device (300).

6. Connecting device according to Claim 1 or 3,
wherein
the first and second contact devices (30) are in the form of a spring contact device (302) to which pressure is applied when the first housing element (20) is arranged relative to the second housing element (40).

## Revendications

1. Dispositif de connexion (2) pouvant être agencé par rapport à un module photovoltaïque (1) en vue de connecter électriquement une pluralité de modules photovoltaïques (1) entre eux et/ou à un dispositif onduleur (6) présentant au moins
un boîtier (3) comportant au moins un premier élément de boîtier (20) pouvant être disposé directement sur le module photovoltaïque (1) et un second élément de boîtier (40),
des premiers dispositifs de connexion (100) pour la connexion électrique au module photovoltaïque (1) disposés dans le premier élément de boîtier (20),
des seconds dispositifs de connexion (600) pour la connexion électrique à un autre dispositif de connexion (2) ou au dispositif onduleur (6) agencé dans le premier élément de boîtier (20) d'un agencement de circuits à semi-conducteurs (50) comportant au moins un composant à semi-conducteurs (500) disposé dans le second élément de boîtier (40), et
des premiers (32) dispositifs de contact (30) qui sont associés au premier élément de boîtier (20) et des seconds (34) dispositifs de contact (30) qui sont associés au second élément de boîtier (40), à la suite de quoi l'agencement de circuits à semi-conducteurs (50) peut être connecté électriquement aux premiers dispositifs de connexion (100), dans lequel l'agencement de circuits à semi-conducteurs (50) en tant qu'unité fonctionnelle comporte au moins un substrat électriquement isolant (54) avec des interconnexions (542) agencées sur celui-ci et des composants à semi-conducteurs (500) reliés matériellement à celui-ci, et dans lequel un dispositif de refroidissement (52) est prévu en contact thermique avec le substrat de l'agencement de circuits à semi-conducteurs (50) et est agencé dans une découpe (44) du second élément de boîtier (40) .

2. Dispositif de connexion selon la revendication 1, dans lequel
l'agencement de circuits à semi-conducteurs (50) peut être connecté électriquement aux seconds dispositifs de connexion (600) dans le premier élément de boîtier (40) au moyen des seconds dispositifs de connexion (600).

3. Dispositif de connexion selon la revendication 1, dans lequel
l'agencement de circuits à semi-conducteurs (50) comporte une pluralité de dispositifs à contact par poussoir (502) ayant chacun un composant à semi-conducteurs dans un boîtier (500) pour établir son contact de force.

4. Dispositif de connexion selon la revendication 1, dans lequel
les premiers et seconds dispositifs de contact (30) connectent l'agencement de circuits à semi-conducteurs (50) aux seconds dispositifs de connexion (600) conformément à l'ensemble des circuits.

5. Dispositif de connexion selon la revendication 1 ou 3, dans lequel
les premiers et seconds dispositifs de contact (30) se présentent sous la forme d'un dispositif de contact enfichable (300).

6. Dispositif de connexion selon la revendication 1 ou 3, dans lequel
les premiers et seconds dispositifs de contact (30) se présentent sous la forme d'un dispositif de contact à ressort (302) auquel une pression est appliquée lorsque le premier élément de boîtier (20) est disposé par rapport au second élément de boîtier (40).
